# FASCICULE DE BREVET EUROPEEN

(11) **EP 2 136 609 B1**
(45) Date de publication et mention de la délivrance du brevet: **21.03.2012**
(21) Numéro de dépôt: 09290433.3
(22) Date de dépôt: 11.06.2009
(51) Int. Cl.: H05K 3/34, H01L 21/60

(54) **Dispositif pour l'assemblage de composants à plots de soudure métalliques**
Vorrichtung zum Zusammensetzen von Komponenten mit Hilfe von Schweißkontaktplättchen aus Metall
Device for assembling components with metal welding studs

(30) Priorité: 18.06.2008 FR 0803397
(43) Date de publication de la demande: 23.12.2009
(73) Titulaire: S.E.T., 74490 St Jeoire (FR)
(72) Inventeur: Cavazza, Gilbert, 74250 Viuz en Sallaz (FR)
(74) Mandataire: Hauer, Bernard

(56) Documents cités:
- EP-A- 1 545 174
- WO-A-2007/097134

## Description

La présente invention concerne un dispositif pour l'assemblage de composants à plots de soudure métalliques, notamment des composants microélectroniques. EP1 545 174 divulgue un procédé pour braser un composant électronique sur une carte électronique.

On sait que, pour assembler des composants par soudure de leurs plots métalliques, il est indispensable que les surfaces métalliques de contact desdits plots soient exemptes d'oxydation.

Or, de telles surfaces de contact s'oxydent naturellement au contact de l'oxygène de l'air ambiant et sont, par conséquent, déjà oxydées avant la soudure. Elles subissent également une oxydation importante lors du chauffage des composants au cours de la soudure, ce qui altère la qualité de cette dernière.

La présente invention a pour objet de remédier à ces inconvénients.

A cette fin, selon l'invention, le dispositif pour l'assemblage de composants à plots métalliques de soudure, notamment des composants microélectroniques, ledit dispositif comportant un premier et un deuxième plateaux en regard aptes à être déplacés de façon relative parallèlement l'un par rapport à l'autre pour pouvoir se rapprocher et s'éloigner, lesdits premier et deuxième plateaux portant respectivement au moins un tel premier composant et au moins un tel deuxième composant et comportant respectivement des moyens de chauffage desdits premier et deuxième composants, ceux-ci étant disposés en regard et leurs plots métalliques respectifs pouvant être amenés au contact les uns des autres par rapprochement desdits premier et deuxième plateaux, est remarquable en ce que :
- ledit premier plateau comporte une première zone extérieure entourant ledit premier composant et pourvue d'au moins :
   ■ un premier orifice radialement proche dudit premier composant et apte à être alimenté par un fluide gazeux désoxydant ;
   ■ un deuxième orifice radialement éloigné dudit premier composant et apte à être alimenté par un fluide gazeux neutre ; et
   ■ un troisième orifice radialement disposé entre ledit premier orifice et ledit deuxième orifice et apte à être relié à des moyens d'aspiration ;
- ledit deuxième plateau comporte une deuxième zone extérieure entourant ledit deuxième composant et est apte à recouvrir au moins en totalité ledit premier plateau ; et
- lorsque lesdits premier et deuxième composants sont au contact l'un de l'autre, lesdits premier et deuxième plateaux ménagent entre eux une chambre plate entourant lesdits premier et deuxième composants.

Ainsi, lorsque les composants sont en contact, le premier orifice peut injecter un mélange gazeux désoxydant, par exemple à base d'acide et d'azote, dans la chambre plate pour saturer l'espace environnant aux composants, ce qui permet, d'une part, de désoxyder lesdites surfaces métalliques de contact et, d'autre part, de les préserver de toute oxydation par l'oxygène de l'air. En outre, le deuxième orifice peut injecter un gaz neutre, par exemple de l'azote, dans l'espace périphérique de la chambre plate pour faire obstacle à une entrée d'air dans ladite chambre plate. De cette façon, en maintenant au sein de la chambre plate une ambiance gazeuse dépourvue d'oxygène, on prévient l'oxydation desdites surfaces métalliques de contact. Enfin, le mélange gazeux désoxydant et le gaz neutre ainsi injectés dans la chambre plate peuvent être aspirés par le troisième orifice, intercalé entre le premier et le deuxième. Ainsi, le mélange gazeux de la chambre plate est renouvelé, ce qui garantit l'absence d'oxygène dans ladite chambre. L'aspiration du mélange gazeux désoxydant empêche également ce dernier de s'échapper de la chambre plate, permettant ainsi une utilisation du dispositif d'assemblage sans risque pour la santé des opérateurs.

A cet effet, il est avantageux que ledit débit de gaz aspiré par ledit troisième orifice soit inférieur à la somme des débits gazeux introduits dans ladite chambre plate. Ainsi, la pression du fluide gazeux dans la chambre plate, injecté par le premier et le deuxième orifices, est au moins légèrement supérieure à la pression atmosphérique de l'air, ce qui empêche toute entrée d'air par le pourtour de la chambre plate.

De façon avantageuse, chacun desdits premier, deuxième et troisième orifices présente la forme d'un anneau entourant ledit premier composant et sont concentriques.

Ainsi, l'injection des fluides gazeux dans la chambre plate est homogène et l'aspiration de ces derniers est performante.

Afin de parfaire encore plus la qualité non oxydante de l'ambiance gazeuse entre lesdits plateaux, ledit premier plateau peut comporter de plus un quatrième orifice apte à injecter un faible débit d'un gaz neutre permettant la saturation en gaz neutre dans une zone entourant ledit premier composant et apte à éventuellement retenir de l'oxygène.

De préférence, ledit deuxième plateau porte, sur le pourtour de ladite deuxième zone extérieure, des moyens aptes à obturer au moins incomplètement le pourtour de ladite chambre plate, lorsque lesdits premier et deuxième composants sont au contact l'un de l'autre.

Ainsi, les moyens d'obturation créent une barrière supplémentaire qui fait obstacle à l'air environnant au dispositif d'assemblage de l'invention. En outre, du fait de l'obturation au moins partielle du pourtour de la chambre plate, la pression augmente sensiblement dans cette dernière, empêchant ainsi l'entrée d'oxygène de l'air dans la chambre plate.

Lesdits moyens d'obturation peuvent être constitués par un anneau rigide prisonnier dudit deuxième plateau, tout en étant libre en coulissement, de façon limitée, parallèlement au déplacement relatif desdits premier et deuxième plateaux et ledit anneau rigide est avantageusement monté libre sur la tige de vérins, aptes à rétracter ledit anneau à l'intérieur dudit deuxième plateau.

Les figures du dessin annexé feront bien comprendre comment l'invention peut être réalisée. Sur ces figures, des références identiques désignent des éléments semblables.

La figure 1 est une vue schématique, en coupe transversale, du dispositif d'assemblage selon une réalisation conforme à la présente invention, lorsque le premier et le deuxième plateaux dudit dispositif sont éloignés l'un de l'autre.

La figure 2 montre, en vue schématique du dessus selon la flèche II de la figure 1, le premier plateau du dispositif de l'invention.

La figure 3 montre, selon une vue semblable à la figure 1, le dispositif de l'invention lorsque l'anneau rigide des moyens d'obturation est au contact du premier plateau. Les premier et deuxième composants sont quant à eux écartés l'un de l'autre.

La figure 4 est semblable à la figure 3, les premier et deuxième composants étant au contact l'un de l'autre.

La figure 5 est une vue schématique agrandie des moyens d'obturation de la figure 1, lorsque les deux plateaux sont éloignés.

La figure 6 est une figure analogue à la figure 5, le premier et le deuxième plateaux étant rapprochés l'un de l'autre.

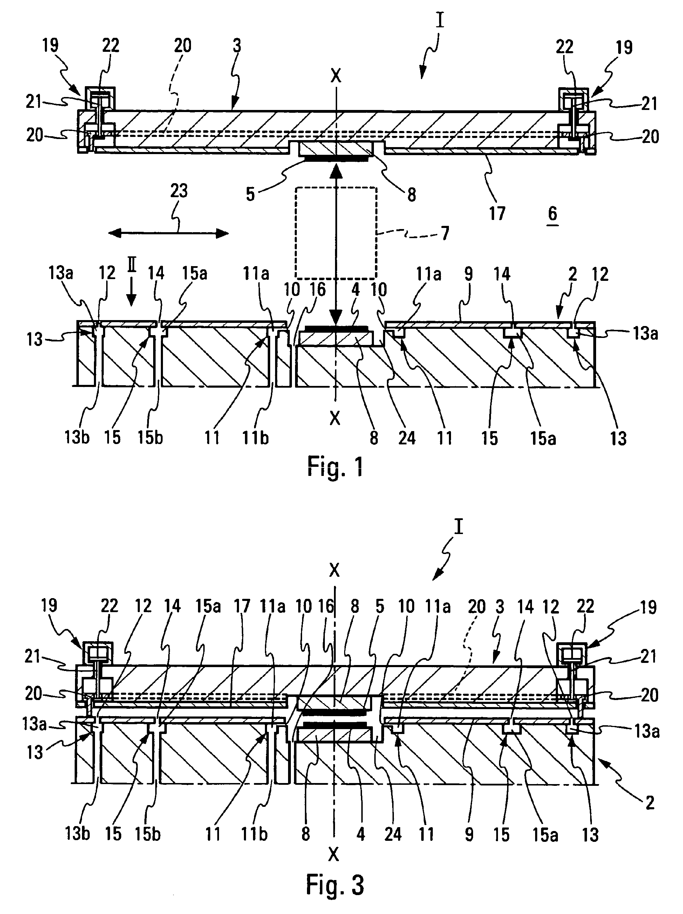

Le dispositif I d'assemblage de composants à plots de soudure métalliques, représenté sur les figures 1, 3 et 4, comporte un premier 2 et un deuxième 3 plateaux en regard l'un de l'autre, par exemple de forme circulaire, qui portent respectivement un premier 4 et un deuxième 5 composants à plots de soudure métalliques. Sur ces figures, lesdits plots de soudure métalliques ne sont pas représentés.

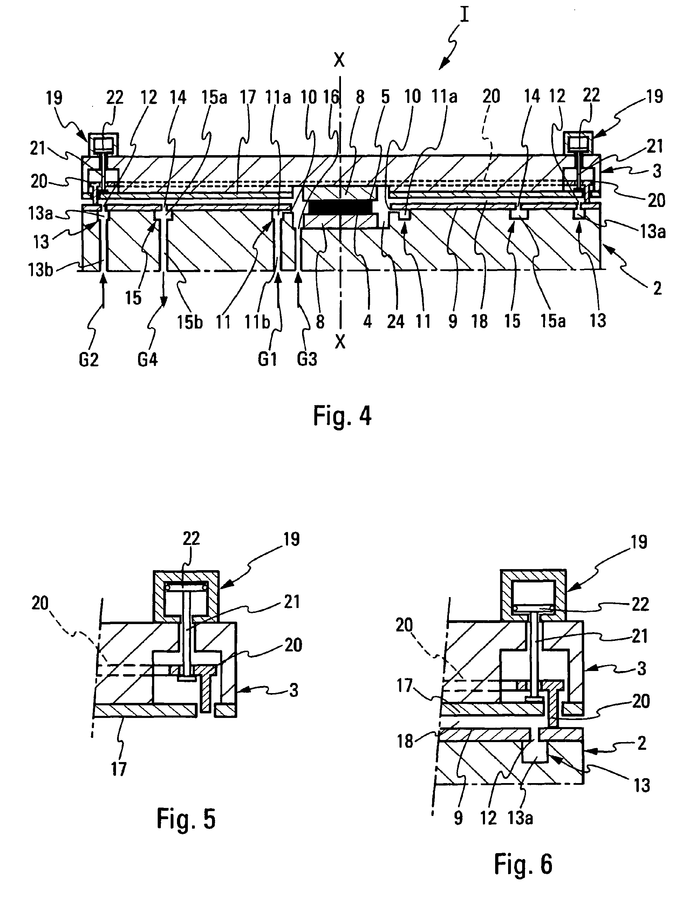

Les deux plateaux 2 et 3 sont aptes à se déplacer, de façon relative, parallèlement l'un par rapport à l'autre selon l'axe X-X, de manière à pouvoir occuper l'une des deux positions suivantes :
- une position éloignée (figure 1) dans laquelle le premier 2 et le deuxième 3 plateaux sont écartés l'un de l'autre. Dans cette position, on peut introduire, dans l'espace intérieur 6 formé entre les deux plateaux 2 et 3, un microscope 7 afin d'aligner précisément le premier 4 et le deuxième 5 composants. Un tel alignement peut par exemple être effectué par un déplacement du deuxième plateau 3 selon deux directions orthogonales (dont l'une est symbolisée par la flèche 23) formant un plan parallèle au premier plateau 2 ; et
- une position de soudage (figure 4) dans laquelle les plots métalliques des premier 4 et deuxième 5 composants sont au contact les uns des autres, prêts à être soudés.

En outre, chaque plateau 2 et 3 comporte des moyens de chauffage disposés sous le composant à assembler. Ces moyens de chauffage sont constitués d'un plateau chauffant 8 sur lequel repose le composant.

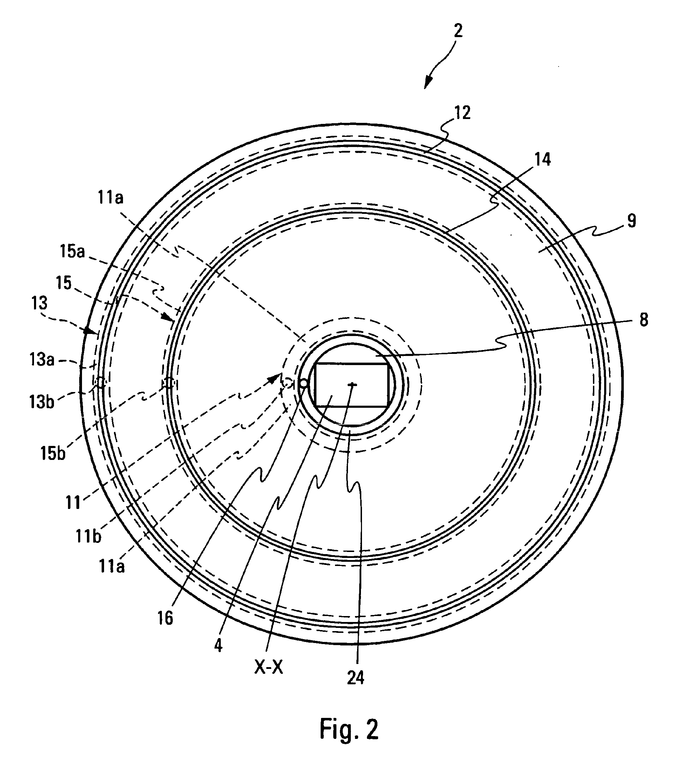

Selon la présente invention, comme le montrent les figures 1 à 4, le premier plateau 2 comporte également une première zone extérieure 9, qui entoure le premier composant 4.

La première zone extérieure 9 comprend :
- un premier orifice 10, radialement proche du premier composant 4. Le premier orifice 10 est apte à être alimenté par un gaz désoxydant (symbolisé par la flèche G1 de la figure 4), au moyen de premiers moyens d'alimentation 11, lorsque le premier 2 et le deuxième 3 plateaux occupent la position de soudage (figure 4). Le premier orifice 10 débouche dans un espace annulaire 24 entourant le plateau chauffant 8 portant le premier composant 4 ;
- un deuxième orifice 12, radialement éloigné du premier composant 4. Le deuxième orifice 1 2 est apte à être alimenté par un gaz neutre (symbolisé par la flèche G2 de la figure 4), au moyen de deuxièmes moyens d'alimentation 13, lorsque les deux plateaux 2 et 3 sont dans la position de soudage. Il débouche en surface de la première zone extérieure 9 du premier plateau 2 ;
- un troisième orifice 14, en surface de la première zone extérieure 9, radialement disposé entre le premier 10 et le deuxième 12 orifice et relié à des moyens d'aspiration 15 ; et
- un quatrième orifice 16, intercalé entre le premier orifice 10 et le plateau chauffant 8 supportant le premier composant 4. Le quatrième orifice 16 est apte à injecter un faible débit de gaz neutre (symbolisé par la flèche G3 de la figure 4) apte à saturer ledit espace annulaire 24 en gaz neutre.

Les premier, deuxième et troisième orifices 10, 12 et 14 présentent la forme d'un anneau entourant le premier composant 4 et sont concentriques.

Tel que représenté sur les figures 1 à 4, les premiers 11 et deuxièmes 13 moyens d'alimentation sont pourvus d'un réservoir de gaz (respectivement 11a et 13a) de forme annulaire logé dans le premier plateau 2 et alimenté en gaz par un canal d'alimentation (respectivement 11b et 13b). L'orifice d'écoulement du réservoir des premiers 11 et deuxièmes 13 moyens d'alimentation correspond respectivement au premier 10 et au deuxième 12 orifices.

Par ailleurs, les moyens d'aspiration 15 sont constitués d'une zone de récupération de gaz 15a, de forme annulaire, ménagée au sein du premier plateau 2 et reliée à un canal d'évacuation 1 5b.

Conformément à l'invention, le deuxième plateau 3 comporte une deuxième zone extérieure 17 entourant le deuxième composant 5 et est apte à recouvrir en totalité le premier plateau 2 dans la position de soudage (figure 4).

Avantageusement, comme le montre la figure 4, dans la position de soudage, le premier 2 et le deuxième 3 plateaux ménagent entre eux une chambre plate 18, qui entoure le premier 4 et le deuxième 5 composants en contact par leurs plots métalliques respectifs.

Selon la réalisation de l'invention représentée, le deuxième plateau 3 porte des moyens d'obturation 19 aptes à obturer le pourtour de ladite chambre plate 18 dans la position de soudage.

Comme le montrent les figures 1, 3 et 4, les moyens d'obturation 19 sont constitués par un anneau rigide 20 prisonnier du deuxième plateau 3 tout en étant libre de coulisser, de façon limitée, parallèlement au déplacement relatif des deux plateaux 2 et 3.

Plus précisément, tel qu'illustré sur les figures 5 et 6, l'anneau rigide 20 est monté libre sur la tige 21 d'un premier et d'un deuxième vérins 22 disposés de façon diamétralement opposée sur la partie supérieure périphérique du deuxième plateau 3. Les vérins 22 sont aptes à rétracter l'anneau rigide 20 à l'intérieur du deuxième plateau 3.

Ainsi, lors de l'écartement relatif des plateaux 2 et 3 de la position de soudage vers la position éloignée, la tige 21 de chacun des deux vérins 22 se rétracte, ce qui provoque la rentrée de l'anneau rigide 20 à l'intérieur du deuxième plateau 3 (figure 1).

En revanche, au cours du rapprochement relatif des deux plateaux 2 et 3 pour atteindre la position de soudage, la tige 21 des deux vérins 22 se déploie, provoquant la sortie, par gravité, de l'anneau rigide 20 du deuxième plateau 3.

Comme le montrent les figures 3 et 4, au contact de la première zone extérieure 9 du premier plateau 2, l'anneau rigide 20 se rétracte légèrement à l'intérieur du deuxième plateau 3 (figure 3) avant que les deux plateaux 2 et 3 n'atteignent la position de soudage (figure 4).

Une fois la position de soudage atteinte, l'anneau rigide 20 obture au moins partiellement le pourtour de la chambre plate 18 et les gaz désoxydant G 1, neutre G2 et neutre de saturation G3 peuvent alors être injectés dans la chambre plate 18, respectivement par les premier 10, deuxième 12 et quatrième 16 orifices.

## Revendications

1. Dispositif pour l'assemblage de composants à plots métalliques de soudure, notamment des composants microélectroniques, ledit dispositif (1) comportant un premier (2) et un deuxième (3) plateaux en regard aptes à être déplacés de façon relative parallèlement l'un par rapport à l'autre pour pouvoir se rapprocher et s'éloigner, lesdits premier (2) et deuxième (3) plateaux portant respectivement au moins un tel premier composant (4) et au moins un tel deuxième composant (5) et comportant respectivement des moyens de chauffage (8) desdits premier (4) et deuxième composants (5), ceux-ci étant disposés en regard et leurs plots métalliques respectifs pouvant être amenés au contact les uns des autres par rapprochement desdits premier (2) et deuxième (3) plateaux, **caractérisé en ce que** :
- ledit premier plateau (2) comporte une première zone extérieure (9) entourant ledit premier composant (4) et pourvue d'au moins :
■ un premier orifice (10) radialement proche dudit premier composant (4) et apte à être alimenté par un fluide gazeux désoxydant (G1) ;
■ un deuxième orifice (12) radialement éloigné dudit premier composant (4) et apte à être alimenté par un fluide gazeux neutre (G2) ; et
■ un troisième orifice (14) radialement disposé entre ledit premier orifice (10) et ledit deuxième orifice (12) et apte à être relié à des moyens d'aspiration (15) ;
- ledit deuxième plateau (3) comporte une deuxième zone extérieure (17) entourant ledit deuxième composant (5) et est apte à recouvrir au moins en totalité ledit premier plateau (2) ; et
- lorsque lesdits premier (4) et deuxième (5) composants sont au contact l'un de l'autre, lesdits premier (2) et deuxième (3) plateaux ménagent entre eux une chambre plate (18) entourant lesdits premier (4) et deuxième (4) composants.

2. Dispositif selon la revendication 1,
**caractérisé en ce que** chacun desdits premier (10), deuxième (12) et troisième (14) orifices présente la forme d'un anneau entourant ledit premier composant (4).

3. Dispositif selon la revendication 2,
**caractérisé en ce que** lesdits premier (10), deuxième (12) et troisième (14) orifices sont concentriques.

4. Dispositif selon l'une des revendications 1 à 3,
**caractérisé en ce que** ledit premier plateau (2) comporte un quatrième orifice (16) apte à injecter un faible débit de gaz neutre de saturation (G3) autour dudit premier composant.

5. Dispositif selon l'une des revendications 1 à 4,
**caractérisé en ce que** ledit débit de gaz aspiré (G4) par ledit troisième orifice (14) est inférieur à la somme des débits gazeux introduits dans ladite chambre plate (18).

6. Dispositif selon l'une des revendications 1 à 5,
**caractérisé en ce que** ledit deuxième plateau (3) porte, sur le pourtour de ladite deuxième zone extérieure (17), des moyens (19) aptes à obturer le pourtour de ladite chambre plate (18), lorsque lesdits premier (4) et deuxième (5) composants sont au contact l'un de l'autre.

7. Dispositif selon la revendication 6,
**caractérisé en ce que** lesdits moyens d'obturation (19) sont constitués par un anneau rigide (20) prisonnier dudit deuxième plateau (3), tout en étant libre en coulissement, de façon limitée, parallèlement au déplacement relatif desdits premier (2) et deuxième (3) plateaux.

8. Dispositif selon la revendication 7,
**caractérisé en ce que** ledit anneau rigide (20) est monté libre sur la tige de vérins (21), aptes à rétracter ledit anneau (20) à l'intérieur dudit deuxième plateau (3).

## Claims

1. A device for assembling components having metal bonding pads, especially microelectronic components, said device (1) comprising a first plate (2) and a second plate (3) facing each other and capable of being moved relative and parallel to each other so as to be able to bring said first (2) and second (3) plates closer together and further apart, said first (2) and second (3) plates bearing at least one such first component (4) and at least one such second component (5) respectively and comprising heating means (8) for heating said first (4) and second (5) components respectively, said components facing each other and their respective metal pads being able to be brought into contact with each other by bringing said first (2) and second (3) plates together,
**characterized in that**:
- said first plate (2) has a first outer zone (9) surrounding said first component (4) and provided with at least:
■ a first orifice (10) radially close to said first component (4) and capable of being supplied with a deoxidizing gaseous fluid (G1),
■ a second orifice (12) radially far from said first component (4) and capable of being supplied with an inert gaseous fluid (G2), and
■ a third orifice (14) placed radially between said first orifice (10) and said second orifice (12) and capable of being connected to suction means (15);
- said second plate (3) has a second outer zone (17) surrounding said second component (5) and is capable of covering at least all of said first plate (2); and
- when said first (4) and second (5) components are in contact with each other, said first (2) and second (3) plates leave between them a flat chamber (18) surrounding said first (4) and second (5) components.

2. The device as claimed in claim 1, **characterized in that** each of said first (10), second (12) and third (14) orifices takes the form of a ring surrounding said first component (4).

3. The device as claimed in claim 2, **characterized in that** said first (10), second (12) and third (14) orifices are concentric.

4. The device as claimed in one of claims 1 to 3, **characterized in that** said first plate (2) includes a fourth orifice (16) capable of injecting an inert saturating gas (G3) with a low flowrate around said first component.

5. The device as claimed in one of claims 1 to 4, **characterized in that** the flowrate of said gas sucked (G4) in via third said orifice (14) is less than the sum of the flowrates of the gases introduced into said flat chamber (18).

6. The device as claimed in one of claims 1 to 5, **characterized in that** said second plate (3) bears, on the perimeter of said second outer zone (17), means (19) capable of sealing the perimeter of said flat chamber (18), when said first (4) and second (5) components are in contact with each other.

7. The device as claimed in claim 6, **characterized in that** said sealing means (19) are formed by a rigid ring (20) captive with said second plate (3), whilst still being free to slide, in a limited manner, parallel to the relative displacement of said first (2) and second (3) plates.

8. The device as claimed in claim 7, **characterized in that** said rigid ring (20) is mounted freely on the rods of actuators (21) capable of retracting said ring (20) into said second plate (3).

## Patentansprüche

1. Vorrichtung zum Zusammensetzen von Bauteilen mit metallischen Lötstützpunkten, im Speziellen von mikroelektronischen Bauteilen, wobei die besagte Vorrichtung (I) eine erste (2) und eine zweite (3) jeweils gegenüberliegende Platte umfasst, die bedingt und parallel zueinander verschoben werden können, um sich einander anzunähern oder voneinander zu entfernen, und die besagten ersten (2) und zweiten (3) Platten jeweils zumindest ein solches erstes Bauteil (4) tragen, und zumindest ein solches zweites Bauteil (5), und sie jeweils Vorrichtungen zum Aufheizen (8) der besagten ersten (4) und zweiten (5) Bauteile umfassen, wobei diese gegenüberliegend angeordnet sind, und ihre jeweiligen metallischen Lötstützpunkte durch Annähern der besagten ersten (2) und zweiten (3) Platten jeweils miteinander in Kontakt gebracht werden können,
**dadurch gekennzeichnet, dass**:
- die besagte erste Platte (2) einen ersten äußeren Bereich (9) umfasst, der das besagte erste Bauteil (4) umgibt, und zumindest versehen ist mit:
- einer ersten Öffnung (10), die sich radial nahe am besagten ersten Bauteil (4) befindet, und durch ein desoxidierendes gasförmiges Fluid (G1) versorgt werden kann;
- einer zweiten Öffnung (12), die sich radial entfernt vom besagten ersten Bauteil (4) befindet, und durch ein neutrales gasförmiges Fluid (G2) versorgt werden kann; und
- einer dritten Öffnung (14), die radial zwischen der besagten ersten Öffnung (10) und der besagten zweiten Öffnung (12) angeordnet ist, und mit Saugvorrichtungen (15) verbunden werden kann;
- die besagte zweite Platte (3) einen zweiten äußeren Bereich (17) umfasst, der das besagte zweite Bauteil (5) umgibt, und die besagte erste Platte (2) zumindest vollständig abdecken kann; und
- die besagten ersten (2) und zweiten (3) Platten, wenn die besagten ersten (4) und zweiten (5) Bauteile einander berühren, zwischen sich eine flache Kammer (18) bilden, die die besagten ersten (4) und zweiten (5) Bauteile umgibt.

2. Vorrichtung nach Anspruch 1,
**dadurch gekennzeichnet, dass** die besagten ersten (10), zweiten (12) und dritten (14) Öffnungen die Form eines Ringes aufweisen, der das besagte erste Bauteil (4) umgibt.

3. Vorrichtung nach Anspruch 2,
**dadurch gekennzeichnet, dass** die besagten ersten (10), zweiten (12) und dritten (14) Öffnungen konzentrisch sind.

4. Vorrichtung nach einem der Ansprüche 1 bis 3,
**dadurch gekennzeichnet, dass** die besagte erste Platte (2) eine vierte Öffnung (16) umfasst, die eine geringe Menge eines neutralen Sättigungsgases (G3) um das besagte erste Bauteil injizieren kann.

5. Vorrichtung nach einem der Ansprüche 1 bis 4,
**dadurch gekennzeichnet, dass** die besagte durch die besagte dritte Öffnung (14) aufgesaugte Gasmenge (G4) kleiner als die Summe der Gasmengen ist, die in die besagte flache Kammer (18) eingeführt werden.

6. Vorrichtung nach einem der Ansprüche 1 bis 5,
**dadurch gekennzeichnet, dass** die besagte zweite Platte (3) am Umfang des besagten zweiten äußeren Bereiches (17) Vorrichtungen (19) trägt, die den Umfang der besagten flachen Kammer (18) abdecken können, wenn die besagten ersten (4) und zweiten (5) Bauteile einander berühren.

7. Vorrichtung nach Anspruch 6,
**dadurch gekennzeichnet, dass** die besagten Abdeckungsvorrichtungen (19) durch einen steifen Ring (20) gebildet werden, der in die besagte zweite Platte (3) eingeschlossen ist, sich jedoch in beschränkter Form und parallel zur Verfahrrichtung der besagten ersten (2) und zweiten (3) Platten verschieben lässt.

8. Vorrichtung nach Anspruch 7,
**dadurch gekennzeichnet, dass** der besagte steife Ring (20) frei auf der Stange der Zylinder (21) montiert ist, die den besagten Ring (20) ins Innere der besagten zweiten Platte (3) einziehen können.
